# EUROPEAN PATENT SPECIFICATION

(11) **EP 1 760 708 B1**
(45) Date of publication and mention of the grant of the patent: **17.12.2008**
(21) Application number: 06015915.9
(22) Date of filing: 31.07.2006
(51) Int. Cl.: G11B 7/243, C23C 14/34

(54) **Recording layer and sputtering target for optical information recording media, as well as optical information recording media**
Aufzeichnungsschicht und Sputtertargets für optische Informationsaufzeichnungsmedien sowie optische Informationsaufzeichnungsmedien
Couche d'enregistrement et cible de pulvérisation pour supports d'enregistrement d'informations optiques aussi bien que pour supports d'enregistrement d'informations

(30) Priority: 30.08.2005 JP 2005250134
(43) Date of publication of application: 07.03.2007
(73) Proprietor: KABUSHIKI KAISHA KOBE SEIKO SHO, Kobe-shi, Hyogo 651-8585 (JP)
(72) Inventor: Fujii, Hideo c/o Kobe Corporate Research Lab. Ltd., Kobe-shi, Hyogo 651-2271 (JP); Ido, Tatewaki c/o Kobe Corporate Res. Lab. Ltd., Kobe-shi, Hyogo 651-2271 (JP); Tauchi, Yuki c/o Kobe Corporate Res. Lab. Ltd., Kobe-shi, Hyogo 651-2271 (JP)
(74) Representative: Müller-Boré & Partner Patentanwälte

(56) References cited:
- EP-A- 0 354 570
- EP-A- 1 235 213
- US-A- 5 413 835

## Description

The present invention relates to a recording layer and a sputtering target for optical information recording media, as well as optical information recording media. The recording layer for optical information recording media of the present invention can be used not only for current compact discs (CDs) and digital versatile discs (DVDs) but also for next generation optical information recording media (HD DVDs and Blu-ray discs), and particularly suitably used for optical information recording media using a blue-violet laser.

Optical information recording media (optical discs) are categorized into three main types that are read-only, rewritable, and write-once according to recording/reading systems.

In write-once optical discs among these discs, data is recorded by principally utilizing changes in properties of materials in the recording layer irradiated with a laser beam. The name, write-once optical discs or the like, originates from the fact that data can be recorded but not erased or rewritten. The write-once optical discs are widely utilized in uses to prevent tampering of data such as text file and image file with the use of such characteristics and include CD-R, DVD-R, DVD+R, and the like.

Materials for the recording layer used for the write-once optical discs include, for example, organic dye materials such as cyanine dyes, phthalocyanine dyes, and azo dyes. When a laser beam is irradiated to an organic dye material, a recording mark is formed by decomposition, melting, evaporation, and the like of a dye and a substrate due to heat absorption by the dye. However, when an organic dye material is used, the dye must be applied to a substrate after dissolving in an organic solvent, which results in a reduction in productivity. There are also problems in respect of storage stability of recorded signals and the like.

Consequently, a method of performing recording, in which a thin film of an inorganic material is used as a recording layer in place of an organic dye material and this thin film is irradiated with a laser beam to form holes (recording marks) or deformations (pits), has been proposed (hereinafter, sometimes referred to as "hole creating recording system") (Non-patent document 1; Patent documents 1 to 7).

Non-patent document 1 discloses a technology in which holes are created by a low laser power with the use of a Te thin film having,a low melting point and low thermal conductivity.

In Non-patent document 1 and Patent document 2, a recording layer consisting of a reaction layer formed of a Cu-based alloy containing Al and another reaction layer containing Si and the like is disclosed. A region where atoms contained in each reaction layer are mixed is partially formed on a substrate by irradiation with a laser beam, and reflectivity in that region is greatly changed; therefore, information can be recorded with high sensitivity even if a laser beam having a short wavelength such as blue laser is used.

Patent documents 3, 4, and 7 are concerned with technologies of optical recording media using the hole creating recording system in which a decrease in carrier to noise ratio in output (C/N) is prevented and high C/N and high reflectivity are provided. As the recording layers in these media, a Cu-based alloy containing In (Patent document 3), a Ag-based alloy containing Bi or the like (Patent document 4), and a Sn-based alloy containing Bi or the like (Patent document 7) are used.

Patent documents 5 and 6 and the above-described Patent document 7 are concerned with Sn-based alloy. Patent document 5 relates to optical recording media, containing in a metal alloy layer, two or more kinds of atoms that can aggregate at least partially at the time of heat treatment. Specifically, for example, a Sn-Cu-based alloy layer (thickness, 1 to 8 nm) containing Bi and In is disclosed, and the use of this makes it possible to obtain a recording medium with a high melting point and high thermal conductivity. In Patent document 6, a recording layer in which a material more readily oxidized than Sn and Bi is added to a Sn-Bi alloy excellent in recording characteristics is disclosed. According to Patent document 6, optical recording media with enhanced durability in a high temperature and high humidity environment (for example, maintained for 120 hours in an environment of a temperature of 60 degrees C and a relative humidity of 90%) can be obtained.
[Patent document 1] JP-A No. 5922/2004
[Patent document 2] JP-A No. 234717/2004
[Patent document 3] JP-A No. 172861/2002
[Patent document 4] JP-A No. 144730/2002
[Patent document 5] JP-A No. 117887/1990
[Patent document 6] JP-A No. 180114/2001
[Patent document 7] JP-A No. 225433/2002
[Non-patent document 1] Appl. Phys. Lett., 34 (1979), p.835

As the demand for high-density information recording grows more and more, it is desired to carry out recording and reading of information using particularly a short wavelength laser beam such as blue-violet laser. Although recording characteristics (low thermal conductivity, high initial reflectivity, creation of recording marks, etc.) are improved by information recording technology based on the hole creating recording system described above, durability of optical recording media is still poor in a high temperature and high humidity environment.

The present invention was accomplished in light of the abovementioned circumstances, and the object of the present invention is to provide a recording layer for optical information recording media and a sputtering target formed of materials forming the recording layer as well as an optical information recording medium provided with the recording layer that are not only excellent in initial reflectivity and creation of recording marks but also extremely excellent in durability under a high temperature and high humidity environment and that can be adequately applied to a next generation optical disc using a blue-violet laser beam.

The essence of the recording layer for optical information recording media of the present invention in which the above problems relate to the recording layer on which recording marks are created by irradiation of a laser beam comprises a Sn-based alloy containing 5 to 50 atomic percent (hereinafter, simply referred to as "at%") of In and/or 12 to 40at% of Zn.

In a preferred embodiment, the thickness of the recording layer is in the range of from 10 nm to 50 nm.

In a preferred embodiment, the wavelength of the laser beam is in the range of from 380 nm to 450 nm.

The sputtering target for optical information recording media of the present invention comprises the Sn-based alloy containing 5 to 50at% of In and/or 12 to 40at% of Zn.

The optical information recording medium of the present invention is provided with either one of the recording layers for optical information recording media.

Since the recording layer of the present invention is formed as described above, the optical information recording media provided with the recording layer are not only excellent in recording characteristics such as initial reflectivity and creation of recording marks but also extremely excellent in durability under a high temperature and high humidity environment. Accordingly, the recording layer of the present invention can be suitably used for a write-once type optical disc on which recording and reading of information can be performed at high density as well as at high speed, and particularly suitably used for a next generation optical disc using a blue-violet laser beam.

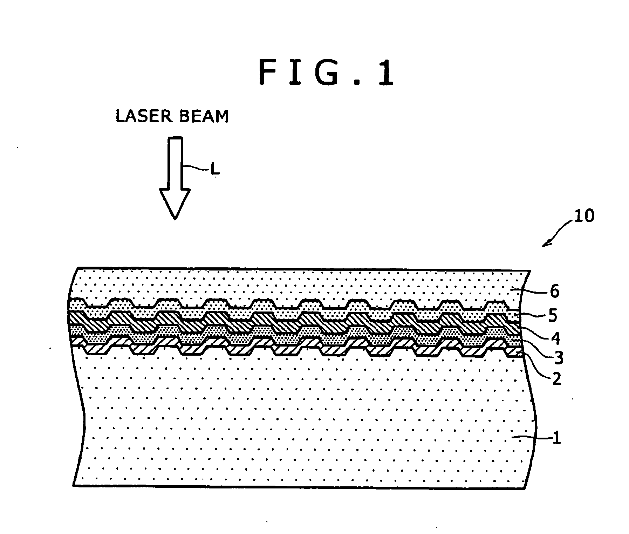

Fig. 1 is a sectional view schematically explaining a structure of an embodiment of optical information recording media according to the present invention.

In order to provide a recording layer extremely excellent in durability (a small decrease in reflectivity) particularly under a high temperature and high humidity environment on which information can be recorded by a hole creating recording system, the present inventors conducted research focusing on a Sn-based alloy. As the result, the present inventors discovered that the desired purpose can be achieved by using a Sn-based alloy containing a predetermined amount of In and/or Zn in Sn and perfected the present invention.

First, how the inventors achieved the present invention is explained in comparison with the conventional technology.

The reason why the inventors focused on a Sn-based alloy in the present invention is as follows. In respect of reflectivity, Sn is inferior to Al, Ag, and Cu, while Sn is superior when recording marks are created by irradiation with a laser beam. The melting point of Sn is about 232 degrees C and significantly lower compared with those of Al (melting point, about 660 degrees C), Ag (melting point, about 962 degrees C), and Cu (melting point, about 1085 degrees C) in the hole creating recording system. Therefore, it was considered that a Sn-based alloy thin film in which alloy atoms are added to Sn is readily melted by irradiation with a laser beam, thereby improving recording characteristics. When application to a next generation optical disc using a blue-violet laser beam was mainly aimed as in the present invention, a Sn-based alloy was selected based on the consideration that the use of Al and the like might make it difficult to create recording marks with ease.

On the other hand, in the present invention, the criterion of durability was defined as a condition that the amount of change in reflectivity (=reflectivity (before test)-reflectivity (after test)) of 405 nm wavelength was maintained for 96 hours in an environment of temperature of 80 degrees C and relative humidity of 85% is less than 15%, preferably less than 10%. Since the wavelength of blue laser is shorter than that of red laser, the change in reflectivity due to film deterioration is more marked. Accordingly, the durability of optical discs on which recording and reading have been performed using a blue laser beam is expected to be decreased compared with when a red laser beam is used. In other words, in order to apply blue laser to an optical disc, durability higher than ever is required. For this reason, in the present invention, the condition that the reflectivity of an optical disc without providing a protective film hardly decreases even when the optical disc was exposed to an extremely harsh condition of maintaining in a high temperature environment of 80 degrees C for a long time period of 96 hours as described above was set up as the criterion of durability. Although the durability of optical discs was examined in Patent documents 1 and 6 described above, the durability was merely examined under an environment milder than the condition defined in the present invention. In Patent document 6, the durability test (maintained for 120 hours at a temperature of 60 degrees C and a relative humidity of 90%) was carried out at a temperature lower than that in the present invention. In Patent document 1, the durability test (maintained for 50 hours at a temperature of 80 degrees C and a relative humidity of 85%) was carried out for a time period shorter than that in the present invention. In both of these, the durability test in a high temperature environment for a long term as performed in the present invention was not carried out.

Next, prototypes of the recording layers of Sn-based alloys in which various alloy components were added in Sn were produced, and not only creation of recording marks when irradiated with a blue laser beam of 405 nm wavelength wasstudied but also changes in reflectivity (durability) when exposed to a high temperature and high humidity environment were studied. The Sn-based alloys disclosed in Patent documents 5 to 7 described above were also studied in a similar manner.

As the result, it was found as described later in detail in Examples that the use of Sn-based alloys added with predetermined amounts of In and Zn not only allowed recording characteristics excellent in creation of recording marks and reflectivity to be maintained but also could satisfy the criterion of durability defined in the present invention.

In contrast, it was found in experiments that the Sn-based alloys disclosed in Patent documents 5 to 7 had the following problems.

In Patent document 5, a metal alloy layer consisting of an alloy of 40% by weight of Sn, 55% by weight of In, and 5% by weight of Cu (film thickness, 2 to 4 nm) is disclosed. When converted to atomic percent, the alloy consists of 37.7 atomic percent of Sn, 53.5 atomic percent of In, and 8.8 atomic percent of Cu, and the addition amount of In is out of the range of the present invention. Therefore, the desired durability could not be obtained. In addition, the thickness of the above metal alloy layer was from 2 nm to 4 nm, and it was found in experiments that high reflectivity could not be obtained with this thickness.

In Patent document 7, an alloy of 84 atomic percent of Sn, 10 atomic percent of Zn, and 6 atomic percent of Sb is disclosed. However, high reflectivity could not be obtained because the addition amount of Zn is below the range of the present invention.

On the other hand, a recording layer in which a material more readily oxidized than Sn and Bi was added to a Sn-Bi alloy is disclosed. However, high technology for thin film formation is required to properly control the amount of the material to be oxidized. In contrast, the present invention can provide a Sn-based alloy formed of a simple composition that does not require high technology for thin film formation.

Hereinafter, the recording layer of the present invention is explained in detail.

The recording layer of the present invention comprises a Sn-based alloy containing 5 to 50 at% of In and/or 12 to 40at% of Zn. As shown in Examples described later, Sn is excellent in recording characteristics such as creation of recording marks, whereas it is poor in durability under a high temperature environment. By adding In or Zn of a predetermined amount, excellent recording characteristics are maintained, yet durability is greatly enhanced. Although the reason why such an effect is acquired is unknown precisely, it is conceivable that the oxidation of Sn is suppressed by adding these alloy atoms and so forth.

In and Zn may be added either alone or in combination.

The addition amount of In is 5at% or more and 50at% or less. When the addition amount of In is less than 5at%, the desired durability cannot be obtained, and the initial reflectivity is also decreased. However, when In is added in excess, the durability is markedly decreased, and therefore the upper limit of the addition amount of In was set to 50at%. The addition amount of In is preferably 12at% or more and 45at% or less, more preferably 15% or more and 30at% or less.

The addition amount of Zn is 12at% or more and 40at% or less. The lower limit of Zn was determined in view of the initial reflectivity. As shown in Examples described later, the effect of durability improvement by Zn can be effectively exerted even if the addition amount is less than 12at%. However, when it becomes less than 12at%, the initial reflectivity is decreased. On the other hand, when Zn is added in excess, the durability is decreased. Therefore, its upper limit was set to 40at%. The addition amount of Zn is preferably 15at% or more and 35at% or less, more preferably 20at% or more and 30at% or less.

Although the recording layer of the present invention contains the above components and the remaining part is Sn, other components may be added within the range that does not deteriorate the effect of the present invention. For example, gas components (O₂, N₂, etc.) inevitably introduced when the recording layer is produced using a sputtering method or impurities contained beforehand in a Sn base alloy used as a dissolving material may be contained.

The thickness of the recording layer is preferably in the range of from 10 nm to 50 nm. As shown in Examples described later, when the thickness of the recording layer is 10 nm or more, the initial reflectivity is enhanced. On the other hand, although the thickness of the recording layer is not limited in view of the initial reflectivity, it is preferred to be in 50 nm or less when creation of recording marks is taken into consideration. The thickness of the recording layer is more preferably 15 nm or more and 40 nm or less, further preferably 20 nm or more and 35 nm or less.

The optical information recording media of the present invention is provided with the recording layer formed of the above Sn-based alloy. The structure other than the recording layer is not particularly limited, and any structure known in the field of optical information recording media can be employed.

The structure of a preferred embodiment of the optical information recording media (optical discs) according to the present invention is shown schematically in Fig. 1. Fig. 1 depicts a write-once type optical disc 10 on which data recording and reading can be carried out by irradiating a blue laser beam having a wavelength ranging from about 380 nm to 450 nm, preferably a wavelength of about 405 nm, to the recording layer. The optical disc 10 is provided with a substrate 1, a optical control layer 2, dielectric layers 3 and 5, a recording layer 4 sandwiched between the dielectric layers 3 and 5, and a light transmission layer 6. The dielectric layers 3 and 5 are provided to protect the recording layer 4, thereby allowing recorded information to be stored for a long term.

The optical disc of the present embodiment has a feature that a Sn-based alloy satisfying the requirements described above is used as a material of the recording layer 4. Materials of the substrate 1 and the layers (the optical control layer 2 and the dielectric layers 3 and 5) other than the recording layer 4 are not particularly limited and are appropriately selected from materials that are conventionally widely used. When a material such as Ag alloy is used for the material of the optical control layer 2, the reflectivity can be enhanced. It should be noted that when the recording layer of the present invention is used, the dielectric layers 3 and 5 can be omitted.

The above Sn-based alloy thin film is desirably produced by a sputtering method. The solubility limit of the alloy atoms (In, Zn) used in the present invention with respect to Sn is 10 atomic percent or less in equilibrium. However, in the thin film formed by the sputtering method, it is possible to make a forced solid solution by rapid cooling of a gas phase peculiar to the sputtering method. Accordingly, compared to when a Sn-based alloy thin film is produced by a method of thin film formation other than the sputtering method, the alloy atoms are uniformly distributed in Sn matrix, resulting in a remarkable increase in the durability or the like.

Further, at the time of sputtering, it is preferred to use a Sn base alloy material produced by a melting and casting method (hereinafter, referred to as "Sn base alloy target material prepared by melting") and the like as a sputtering target material. Since not only the structure of the Sn base alloy target material prepared by melting is uniform but also sputtering rate and output angle are uniform, a recording layer of a Sn-based alloy thin film having a uniform component composition can be stably obtained, resulting in production of optical discs with higher performance. In addition, when the oxygen content in the Sn base alloy target material prepared by melting is controlled to 100 ppm or lower, it becomes easy to keep the rate of film formation constant, and further the oxygen amount in the Sn-based alloy thin film becomes low; therefore, the reflectivity and durability of the Sn-based alloy thin film is more enhanced.

### EXAMPLES

Hereinafter, the present invention is explained in detail by way of Examples. However, the following Examples do not limit the scope of the present invention, and appropriate modifications without departing from the spirit and scope of the present invention set forth above and below fall within the technological scope of the present invention.

### Prototype samples

Prototype samples of various Sn-based alloy thin films shown in Table I were produced as described below, and these were examined for the initial reflectivity, creation of recording marks, and durability. For comparison, a pure Sn thin film was also examined for the above characteristics in a similar manner. Formation of Sn-based alloy thin film and pure Sn thin film

A pure Sn thin film or a Sn-based alloy thin film was formed on a transparent polycarbonate substrate (thickness, 0.6mm; diameter, 120 mm) using a pure Sn sputtering target. The Sn-based alloy thin film was formed using a composited sputtering target with chips of alloy elements to be added on the pure Sn sputtering target. Sputtering conditions were set to Ar flow of 30 sccm, Ar gas pressure of 2 mTorr, sputtering power of 50 W DC, and base pressure of 10⁻⁵ Torr or lower. The thicknesses of the Sn-based alloy thin film were varied within the range shown in Table I by changing the sputtering time between 5 sec and 45 sec. The compositions of the Sn-based alloy thin films obtained in this way were determined by ICP mass spectrometry.

### Creation of recording marks

A blue laser beam was irradiated to the above-described samples as follows while changing the magnitude of laser power to create recording marks. The laser beam was irradiated from the side of the Sn-based alloy thin film.
Light source: semiconductor laser having a wavelength of 405 nm
Spot size of laser: 0.8 µm in diameter
Linear velocity: 10 m/s

The shapes of thus-created recording marks were observed by an optical microscope (magnification, 1000 times), and the ratio of the area of recording mark formed to the area of laser beam irradiation (area ratio) was calculated. In the present invention, a sample that showed the area ratio of 85% or higher was accepted, and the creation of recording marks was evaluated based on the following criteria:
Very good: An area ratio of 85% or higher is obtained even when irradiated with a laser beam with a low laser power equal to or higher than 10 mW and equal to or lower than 15 mW.
Good: An area ratio of 85% or higher is obtained when irradiated with a laser beam with a laser power higher than 15 mW and equal to or lower than 25 mW.
Poor: An area ratio of 85% or higher is not obtained even when irradiated with a laser beam with a laser power higher than 25 mW. Measurement of initial reflectivity

Absolute spectral reflectivities of thin films right after forming the films by sputtering (before creating recording marks) were measured in wavelengths ranging from 1000 to 250 nm using a UV/Vis spectrophotometer "V-570" of JASCO Corporation. In the present invention, a sample having initial reflectivity higher than 30% at 405 nm wavelength was accepted.

### Measurement of durability

The samples measured for the initial reflectivity as above were subjected to a high temperature and high humidity test in which the samples were maintained for 48 hours or 96 hours in an atmospheric environment of a temperature of 80 degrees C and a relative humidity of 85%, and then the absolute spectral reflectivities of the samples were measured in the same way as above. The difference of the reflectivities at 405 nm wavelength before and after the high temperature and high humidity test (amount of reflectivity decrease after completion of the test) was calculated, and the durability was evaluated based on the following criteria. In the present invention, the results of the high temperature and high humidity test when maintained for 96 hours that are shown by "excellent", "very good", and "good" were accepted.
Excellent: Reflectivity decrease was less than 10%.
Very good: Reflectivity decrease was equal to or more than 10% and less than 15%.
Good: Reflectivity decrease was equal to or more than 15% and less than 20%.
Poor: Reflectivity decrease was equal to or more than 20%.

These results are summarized in Table I.

**Table I**

| Sample | Composition (in atomic percent) | Thickness (nm) | Initial reflectivity | Creation of recording marks | Durability | |
|---|---|---|---|---|---|---|
| | | | | | 48 hrs | 96 hrs |
| 1 | Sn-5% In | 12 | Good | Very good | Very good | Good |
| 2 | Sn-5% In | 30 | Good | Very good | Very good | Good |
| 3 | Sn-10% In | 30 | Good | Very good | Very good | Good |
| 4 | Sn-15% In | 30 | Good | Very good | Excellent | Excellent |
| 5 | Sn-30% In | 30 | Good | Very good | Excellent | Excellent |
| 6 | Sn-30% In | 50 | Good | Good | Excellent | Excellent |
| 7 | Sn-50% In | 30 | Good | Very good | Very good | Good |
| 8 | Sn-13% Zn | 30 | Good | Very good | Excellent | Very good |
| 9 | Sn-30% Zn | 30 | Good | Very good | Excellent | Very good |
| 10 | Sn-40% Zn | 30 | Good | Very good | Excellent | Very good |
| 11 | Sn | 30 | Good | Very good | Poor | Poor |
| 12 | Sn-4% In | 30 | Poor | Very good | Very good | Poor |
| 13 | Sn-5% In | 8 | Poor | Very good | Very good | Good |
| 14 | Sn-30% In | 8 | Poor | Very good | Excellent | Very good |
| 15 | Sn-10% In | 70 | Poor | Poor | Very good | Very good |
| 16 | Sn-55% In | 30 | Good | Very good | Good | Poor |
| 17 | Sn-10% Zn | 30 | Poor | Very good | Excellent | Very good |
| 18 | Sn-30% Zn | 70 | Good | Poor | Excellent | Very good |
| 19 | Sn-30% Zn | 8 | Poor | Very good | Very good | Very good |
| 20 | Sn-45% Zn | 30 | Good | Very good | Good | Poor |
| 21 | Sn-5% A1 | 30 | Good | Very good | Good | Poor |
| 22 | Sn-5% Cu | 30 | Poor | Good | Very good | Good |

The following considerations can be made from Table I.

The samples 1 to 10 that satisfy the requirements in the present invention are provided with not only very good recording characteristics as evidenced by the initial reflectivity and creation of recording marks but also excellent durability.

In contrast, the samples 11 to 22 have the following defects.

The sample 11 formed of a pure Sn thin film is inferior in the durability.

The samples 12 to 16 are examples of Sn-In alloy thin films added with In as an alloy atom. The sample 12 with a smaller amount of In added and the sample 16 with a larger amount of In added both showed a reduction in the durability. The sample 12 showed a decrease in the initial reflectivity as well. The samples 13 and 14 are examples in which the thicknesses of the alloy thin films fell short of the desired range of the present invention, and both samples showed a decrease in the initial reflectivity. The sample 15 is an example in which the thickness of the alloy thin film exceeded the desired range of the present invention, and the creation of recording marks was decreased.

The samples 17 to 20 are examples of Sn-Zn alloy thin films added with Zn as an alloy atom. The sample 17 with a smaller amount of Zn added showed a decrease in the initial reflectivity, and the sample 20 with a larger amount of Zn added showed a reduction in the durability. The sample 18 showed a decrease in the creation of recording marks because the thicknesses of the alloy thin film exceeded the desired range of the present invention. The sample 19 showed a decrease in the initial reflectivity because the thicknesses of the alloy thin film fell short of the desired range of the present invention.

The samples 21 and 22 are examples in which Al or Cu was added as an alloy atom other than In and Zn, and both samples showed a decrease in the durability. The sample 22 showed a decrease in the initial reflectivity as well.

Although the polycarbonate substrate having a thickness of about 0.6 mm was used in the above examples, the substrate is not limited to this, and for example, a resin substrate having a thickness of about 1.1 mm may also be used. Further, even when a red laser beam was used in place of the blue laser beam, it was confirmed by experiments that excellent characteristics could be obtained.

## Claims

1. A recording layer for optical information recording media to create recording marks by irradiating a laser beam, the recording layer comprising a Sn-based alloy containing 5 to 50 atomic percent of In and/or 12 to 40 atomic percent of Zn.

2. The recording layer for optical information recording media according to claim 1, wherein the thickness of the recording layer is in the range of 10 nm to 50 nm.

3. The recording layer for optical information recording media according to claim 1 or 2, wherein the wavelength of the laser beam is in the range of 380 nm to 450 nm.

4. A sputtering target for optical information recording media comprising a Sn-based alloy containing 5 to 50 atomic percent of In and/or 12 to 40 atomic percent of Zn.

5. An optical information recording medium comprising a recording layer for optical information recording media according to any one of claims 1 to 3.

## Patentansprüche

1. Aufzeichnungsschicht für optische Informationsaufzeichnungsmedien zum Erzeugen von Aufzeichnungsmarkierungen durch Bestrahlung mit einem Laserstrahl, wobei die Aufzeichnungsschicht eine Sn-basierte Legierung umfaßt, die 5 bis 50 Atomprozent In und/oder 12 bis 40 Atomprozent Zn enthält.

2. Aufzeichnungsschicht für optische Informationsaufzeichnungsmedien nach Anspruch 1, wobei die Dicke der Aufzeichnungsschicht im Bereich von 10 nm bis 50 nm ist.

3. Aufzeichnungsschicht für optische Informationsaufzeichnungsmedien nach Anspruch 1 oder 2, wobei die Wellenlänge des Laserstrahls im Bereich von 380 nm bis 450 nm ist.

4. Zerstäubungstarget für optische Informationsaufzeichnungsmedien, umfassend eine Sn-basierte Legierung, die 5 bis 50 Atomprozent In und/oder 12 bis 40 Atomprozent Zn enthält.

5. Optisches Informationsaufzeichnungsmedium, umfassend eine Aufzeichnungsschicht für optische Informationsaufzeichnungsmedien nach einem der Ansprüche 1 bis 3.

## Revendications

1. Couche d'enregistrement pour support d'enregistrement d'informations optiques destinée à créer des repères d'enregistrement par rayonnement d'un faisceau laser, la couche d'enregistrement comprenant un alliage à base de Sn contenant 5 à 50 % atomiques de In et/ou 40 % atomiques de Zn.

2. Couche d'enregistrement pour support d'enregistrement d'informations optiques selon la revendication 1, dans laquelle l'épaisseur de la couche d'enregistrement est dans la plage de 10 nm à 50 nm.

3. Couche d'enregistrement pour support d'enregistrement d'informations optiques selon la revendication 1 ou 2, dans laquelle la longueur d'onde du faisceau laser est dans la plage de 380 nm à 450 nm.

4. Cible de pulvérisation pour support d'enregistrement d'informations optiques comprenant un alliage à base de Sn contenant 5 à 50 % atomiques de In et/ou 12 à 40 % atomiques de Zn.

5. Support d'enregistrement d'informations optiques comprenant une couche d'enregistrement pour support d'enregistrement d'informations optiques selon l'une quelconque des revendications 1 à 3.
